(19) Europäisches Patentamt
European Patent Office
Office européen des brevets

(11) **EP 1 315 975 B1**

(12) **EUROPÄISCHE PATENTSCHRIFT**

(45) Veröffentlichungstag und Bekanntmachung des Hinweises auf die Patenterteilung:
**29.03.2006 Patentblatt 2006/13**

(51) Int Cl.:
**G01R 1/073** (2006.01)

(21) Anmeldenummer: **01974129.7**

(22) Anmeldetag: **07.08.2001**

(86) Internationale Anmeldenummer:
**PCT/EP2001/009133**

(87) Internationale Veröffentlichungsnummer:
**WO 2002/021893 (14.03.2002 Gazette 2002/11)**

(54) **VERFAHREN UND VORRICHTUNG ZUM PRÜFEN VON LEITERPLATTEN MIT EINEM PARALLELTESTER**

METHOD AND DEVICE FOR TESTING PRINTED CIRCUIT BOARDS WITH A PARALLEL TESTER

PROCEDE ET DISPOSITIF POUR TESTER DES CARTES DE CIRCUITS IMPRIMES AU MOYEN D'UN TESTEUR EN PARALLELE

(84) Benannte Vertragsstaaten:
**AT DE FI GB IT**

(30) Priorität: **05.09.2000 DE 10043728**

(43) Veröffentlichungstag der Anmeldung:
**04.06.2003 Patentblatt 2003/23**

(73) Patentinhaber: **atg test systems GmbH & Co. KG 97877 Wertheim (DE)**

(72) Erfinder: **ROTHAUG, Uwe 97828 Marktheidenfeld (DE)**

(74) Vertreter: **Ganahl, Bernhard et al Huber & Schüssler Patentanwälte Truderinger Strasse 246 81825 München (DE)**

(56) Entgegenhaltungen:
EP-A- 0 651 260 EP-A- 0 864 874
DE-A- 4 417 811 US-A- 4 348 276

**Beschreibung**

Die Erfindung betrifft ein Verfahren und eine Vorrichtung zum Prüfen von Leiterplatten, insbesondere zum Prüfen von unbestückten Leiterplatten.

Leiterplatten weisen eine Vielzahl Netze auf, deren Dichte sich mit der kontinuierlich fortsetzenden Miniaturisierung der elektronischen Bauelemente zunehmend erhöht. In entsprechender Weise erhöht sich auch die Dichte der Kontaktstellen der Leiterplatten, die im nachfolgenden als Leiterplattentestpunkte bezeichnet werden.

Bekannte Vorrichtungen zum Prüfen von Leiterplatten können grundsätzlich in zwei Gruppen eingeteilt werden. Die erste Gruppe wird durch Paralleltester dargestellt, die einen Adapter aufweisen, mit welchem alle abzutastenden Leiterplattentestpunkte einer Leiterplatte gleichzeitig kontaktiert werden. Die zweite Gruppe umfasst sequentielle Tester. Hierunter fallen insbesondere die Fingertester. Das sind Vorrichtungen, die mit zwei oder mehreren Kontaktfingern einzelne Leiterplattentestpunkte sequentiell abtasten.

Paralleltester bzw. Adapter für Paralleltester gehen beispielsweise aus der DE 38 14 620 A, der DE 38 18 686 A, der DE 42 37 591 A1, der DE 44 06 538 A1, der DE 38 38 413 A1, der DE 43 23 276 A, der EP 215 146 B1 und der EP 144 682 B1 hervor.

Derartige Adapter dienen grundsätzlich dazu, die ungleichmäßige Konfiguration der Leiterplattentestpunkte der zu testenden Leiterplatte an das gleichmäßige Kontaktraster der elektrischen Prüfvorrichtung anzupassen. Heutzutage sind die Leiterplattentestpunkte üblicherweise nicht in einem gleichmäßigen Raster angeordnet, weshalb die die Verbindungen zwischen dem Kontaktraster und den Leiterplattentestpunkten herstellenden Kontaktnadeln im Adapter mit einer Schrägstellung bzw. Auslenkung angeordnet sind und/oder ein sogenannter Translator vorgesehen ist, der das gleichmäßige Kontaktraster in die ungleichmäßige Konfiguration der Leiterplattentestpunkte "übersetzt".

Von der Fa. Mikrokontakt AG, Güterstr. 7, CH-4654 Lostorf wird unter dem Handelsnamen "MT 100" ein Testgerät für Feinstleiterschaltungsträger angeboten. Dieses Testgerät ist ein Paralleltester, der einen Adapter aufweist. Die zu testende Leiterplatte wird vor dem Testvorgang optisch erfasst und auf dem Adapter entsprechend ausgerichtet. Mit diesem Paralleltester kann eine Leiterplattentestpunktdichte von 645 Leiterplattentestpunkten pro Quadratzoll abgetastet werden.

Ein weiteres Verfahren zum Ausrichten einer Leiterplatte in einem Paralleltester ist in der EP 0 874 243 A2 beschrieben. Bei diesem Verfahren wird die Position der Leiterplatte nicht optisch sondern elektrisch mittels der in den Adapter integrierten Kontaktelementen erfasst. Nach Maßgabe der erfassten Position wird die Leiterplatte auf dem Adapter ausgerichtet.

Fingertester sind beispielsweise aus der DE 41 09 684 A1 bzw. der EP 0 864 874 A bekannt. Fingertester weisen eine hohe Flexibilität auf, da beim Wechsel des zu testenden Leiterplattentyps keine mechanischen Änderungen vorgenommen werden müssen. Fingertester sind jedoch gegenüber mit Adapter arbeitenden Vorrichtungen grundsätzlich langsamer, da die Leiterplattentestpunkte sequentiell abgetastet werden.

An Paralleltestern hingegen ist nachteilig, dass deren Auflösung begrenzt ist, da die Prüfnadeln eines Adapters nicht beliebig eng aneinander angeordnet werden können. Bei Leiterplatten mit hoher Kontaktpunktdichte kann dies zu Fehlmessungen führen, da einzelne Leiterplattentestpunkte nicht korrekt mit den Prüfnadeln eines Adapters kontaktiert werden.

Unabhängig von der Art der Vorrichtungen werden die einzelnen Netze auf Unterbrechungen in den Netzen "(Unterbrechungstest") und auf elektrische Verbindungen zu anderen Netzen ("Kurzschlusstest") getestet. Der Kurzschlusstest kann sowohl die Detektion von niederohmigen als auch von hochohmigen Verbindungen umfassen.

Aus der DE 195 00 382 A1 ist ein Verfahren zum Kompensieren von Substratverzerrungen in einem automatischen optischen Prüfsystem für Leiterplatten bekannt. Bei diesem Prüfsystem wird ein abgetastetes Bild mit einem CAD-Bild verglichen und beim Vergleichen werden Öffnungen, Brücken, Mäusebisse, Vorsprünge, Nadelstiche und Spritzer als Defekte analysiert. Um genau diese Defekte erkennen zu können, müssen die beiden zu vergleichenden Bilder aneinander angepasst werden, wodurch die Verzerrungen der zu testenden Leiterplatte ausgeglichen werden.

Der Erfindung liegt die Aufgabe zugrunde, ein Verfahren zum Testen von Leiterplatten zu schaffen, mit welchem Leiterplatten mit hoher Leiterplattentestpunktdichte schnell und sicher getestet werden können.

Die Aufgabe wird durch ein Verfahren mit den Merkmalen der Anspruchs 1 und durch eine Vorrichtung mit den Merkmalen des Anspruchs 17 gelöst. Vorteilhafte Ausgestaltungen sind in den Unteransprüchen angegeben.

Mit dem erfindungsgemäßen Verfahren zum Prüfen von Leiterplatten wird ein Paralleltester verwendet, wobei die Leiterplatten Leiterbahnen aufweisen, deren Endpunkte Leiterplattentestpunkte sind, die zum Testen kontaktiert werden können. Das Verfahren umfasst folgende Schritte:

-    Testen einer zu testenden Leiterplatte mit einem Paralleltester, wobei Leiterplattentestpunkte der zu testenden Leiterplatte mit Kontaktelementen des Paralleltesters in Kontakt gebracht werden,

-    Bestimmen von Leiterplattentestpunkten, die entweder als nicht sicher korrekt mit den Paralleltester kontaktierbar zu bewerten sind oder die grundsätzlich mit dem Paralleltester nicht kontaktierbar sind, und

-    Nachmessen der als nicht sicher korrekt kontaktierbar bewertbaren Leiterplattentestpunkte bzw. der nicht kontaktierbaren Leiterplattentestpunkte und den damit verbundenen Leiterbahnen mit einer von den Kontaktelementen des Paralleltesters unabhängigen Einrichtung.

Mit dem erfindungsgemäßen Verfahren werden zunächst die überwiegende Zahl der Leiterplattentestpunkte mit einem Paralleltester getestet. Danach wird bestimmt, ob Leiterplattentestpunkte als nicht sicher kontaktierbar zu bewerten sind oder ob sie grundsätzlich nicht kontaktierbar sind.

Grundsätzlich nicht kontaktierbar sind z.B. Leiterplattentestpunkte, für welche am Paralleltester keine entsprechenden Kontaktelemente vorgesehen sind. Das Weglassen von Kontaktelementen am Paralleltester ist für folgende Gruppen von Leiterplattentestpunkten zweckmäßig:

- Es gibt Leiterplattentestpunkte, die sogenannten Bondpads, an welchen möglichst keine Nadelabdrücke einer Prüfnadel eines Paralleltesters eingebracht werden sollen.
- Bei hoher Prüfpunktdichte können in einem Bereich alle Kontaktpunkte des Paralleltesters belegt sein, obwohl nicht alle Leiterplattentestpunkte kontaktiert sind.

Als nicht sicher korrekt kontaktierbar müssen folgende Gruppen von Leiterplattentestpunkten bewertet werden:

- Es gibt Leiterplattentestpunkte die derart stark von ihrer Idealposition abweichen, dass die Gefahr besteht, dass sie nicht mehr korrekt von den in der Idealposition angeordneten Kontaktelementen des Paralleltesters kontaktiert werden.
- Es gibt Leiterplattentestpunkte, die kleiner (z.B. mit einem Durchmesser von 100 μm) als die Spezifikation der Kontaktelemente (Genauigkeit von z.B. 200 μm) sind.

Durch das Nachmessen der als nicht sicher korrekt kontaktierbar bewertbaren Leiterplattentestpunkte bzw. der nicht kontaktierbaren Leiterplattentestpunkte und den damit verbundenen Leiterbahnen mit einer von den Kontaktelementen des Paralleltesters unabhängigen Einrichtung werden somit die mit dem Paralleltester nicht sicher abtastbaren Leiterplattentestpunkte und die damit verbundenen Leiterbahnen nachgemessen.

Mit dem erfindungsgemäßen Verfahren können somit Leiterplatten mit dem Paralleltester zunächst sehr schnell getestet werden, wobei die relativ wenigen mit dem Paralleltester nicht oder nicht sicher korrekt kontaktierbaren Leiterplattentestpunkte mit einer weiteren Testeinrichtung nachgemessen werden. Da die meisten Leiterplattentestpunkte bereits mit dem Paralleltester getestet worden sind, erfolgt das Nachmessen selbst bei Verwendung einer sequentiell arbeitenden Testeinrichtung in relativ kurzer Zeit, so dass der gesamte Zeitbedarf zum Testen einer Leiterplatte äußerst gering ist. Zum Nachmessen wird vorzugsweise ein sequentieller Tester verwendet, da mit sequentiellen Testern Leiterplattentestpunkte, die gegenüber ihrer Idealposition abweichen, einfach und sicher abgetastet werden können.

Mit der erfindungsgemäßen Verfahren können somit Leiterplatten mit hoher Kontaktpunktdichte mit einem hohen Durchsatz getestet werden.

Nach einer bevorzugten Ausführungsform der Erfindung werden als Abweichung gegenüber der Idealposition sowohl lineare Versätze, Winkelversätze als auch eine Verschiebung durch eine lineare oder zwei-dimensionale Verzerrung berücksichtigt.

Nach einer weiteren Abwandlung der Erfindung werden Abweichungen von Leiterplattentestpunkten gegenüber der jeweiligen Idealposition sowohl aus Abweichungen einer Kupferbeschichtung, aus der die Leiterplattentestpunkte ausgebildet sind, sowie aus einer Abweichung von der Idealposition eines Lötstoplacks ermittelt, welche einen Teil der Leiterplattentestpunkte zumindest bereichsweise begrenzt.

Bei dem erfindungsgemäßen Verfahren wird vorzugsweise eine Halteplatte verwendet, in der die zu testende Leiterplatte formschlüssig eingelegt werden kann, wobei die Abweichungen der Leiterplattentestpunkte gegenüber ihrer Idealposition auf der Halteplatte ermittelt werden, so dass diese Abweichungen eindeutig sowohl beim Testen mit dem Paralleltester als auch beim Nachmessen bestimmt sind.

Das Bestimmen der nicht korrekt kontaktierbaren Leiterplattentestpunkte der Leiterplattentestpunkte gegenüber ihrer Idealposition kann sowohl vor als auch nach dem Testen der Leiterplatte mit dem Paralleltester erfolgen. Es ist jedoch bevorzugt, dass vor dem Testen mit dem Paralleltester zumindest ein linearer Versatz der Leiterplattentestpunkte gegenüber ihrer Idealposition ermittelt wird, so dass der Adapter des Paralleltesters und die zu testende Leiterplatte bezüglich dieses linearen Versatzes ausgerichtet werden. Weitere Versätze oder Verzerrungen können bei der Ausrichtung im Paralleltester prinzipbedingt nicht berücksichtigt werden.

Die Erfindung wird nachfolgend beispielhaft näher anhand der Zeichnungen erläutert. In den Zeichnungen zeigen:

Fig. 1 schematisch eine erfindungsgemäße Vorrichtung zum Ausführen des erfindungsgemäßen Verfahrens,

Fig. 2 das erfindungsgemäße Verfahren schematisch in einem Flussdiagramm,

Fig. 3 schematisch die Kompensation eines linearen Versatzes mittels einer Testmarkierung,

Fig. 4 die Kompensation eines linearen Versatzes und eines Winkelversatzes mittels zweier Testmarkierungen,

Fig. 5a      die Kompensation eines linearen Versatzes, eines Winkelversatzes und einer Verzerrung mittels dreier Testmarkierungen,

Fig. 5b      schematisch die mit dem Verfahren nach Fig. 5a kompensierbaren Verzerrungen,

Fig. 6a      eine Kompensation mittels vier Testmarken,

Fig. 6b      die gegenüber dem Verfahren nach Fig. 5a zusätzlich mögliche Kompensation der Verzerrung mit dem Verfahren nach Fig. 6a,

Fig. 7a      die Kompensation von Versätzen und Verzerrungen, wobei die zu testende Leiterplatte in mehrere Bereiche unterteilt ist,

Fig. 7b      schematisch eine zusätzliche Verzerrung, die mit dem Verfahren nach Fig. 7a kompensiert werden kann,

Fig. 8      schematisch die gleichzeitige Kompensation von Versätzen und Verzerrungen mehrerer Leiterplatten,

Fig. 9a      schematisch eine Anordnung mehrerer Leiterplattentestpunkte, die zum Teil zumindest bereichsweise von einem Lötstoplack begrenzt sind,

Fig. 9b      die Abweichungen der in Fig. 9a gezeigten Leiterplattentestpunkte auf Grund eines Versatzes des Lötstoplackes,

Fig. 10      zwei virtuelle Testmarkierungen,

Fig. 11      die Kompensation eines bereichsweise von Lötstoplack begrenzten Leiterplattentestpunktes mittels eines Vektordiagramms,

Fig. 12a      eine Halteplatte in der Draufsicht, und

Fig. 12b      die Halteplatte aus Fig. 12a in einer Schnittsdarstellung.

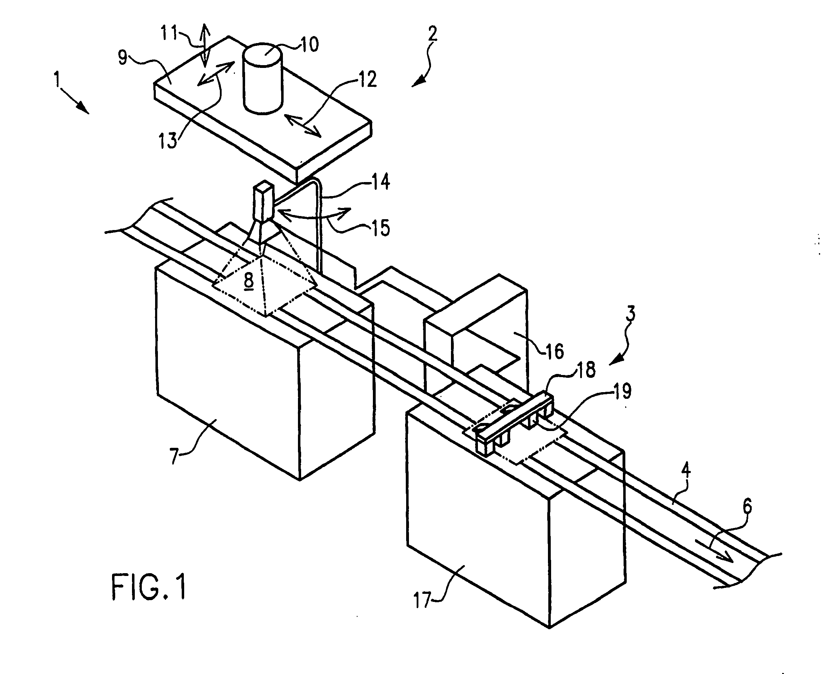

Fig. 1 zeigt schematisch eine erfindungsgemäße Vorrichtung 1 zum Testen von Leiterplatten. Diese Vorrichtung 1 weist einen Paralleltester 2 und einen Fingertester 3 auf. Der Paralleltester 2 und der Fingertester 3 sind mit einer Fördereinrichtung 4 verbunden, die im vorliegenden Ausführungsbeispiel aus zwei Förderbändern 5 ausgebildet ist. Mit der Fördereinrichtung 4 können die zu testenden Leiterplatten in Förderrichtung 6 von einer an sich bekannten und nicht dargestellten Vereinzelungseinrichtung zum Paralleltester 2 und vom Paralleltester 2 zum Fingertester 3 und vom Fingertester 3 zu einer an sich bekannten und nicht dargestellten Sammelstation befördert werden.

Der Paralleltester 2 weist einen Grundkörper 7 auf, an dessen Oberseite ein Aufnahmebereich 8 zum Aufnehmen einer zu testenden Leiterplatte angeordnet ist. Bei beidseitig zu testenden Leiterplatten ist am Aufnahmebereich 8 ein Adapter mit Kontaktelementen zum Kontaktieren von Leiterplattentestpunkten vorgesehen. Gegenüber dem Aufnahmebereich 8 ist eine Andruckplatte 9 angeordnet. Diese Andruckplatte 9 ist mittels eines Andruckmechanismus vertikal in Richtung des Doppelpfeils 11 verstellbar. Der Andruckmechanismus ist schematisch durch einen Andruckzylinder 10 dargestellt. An der Unterseite der Andruckplatte 9 ist ein Adapter angeordnet, der Kontaktelemente zum Kontaktieren einer zu prüfenden Leiterplatte aufweist. Die Andruckplatte 9 wird beim Testen mit dem Adapter gegen eine im Aufnahmebereich 8 angeordnete Leiterplatte gedrückt, so dass die Kontaktelemente jeweils einen elektrischen Kontakt zu einem Leiterplattentestpunkt der Leiterplatte bilden. Die Andruckplatte 9 kann in der horizontalen Ebene sowohl in X-Richtung (Doppelpfeil 12) als auch in Y-Richtung (Doppelpfeil 13) zum Ausrichten auf die zu prüfende Leiterplatte bewegt werden.

In Fig. 1 ist zwischen der Andruckplatte 9 und dem Grundkörper 7 eine Kamera angeordnet. Die Kamera 14 ist mit Blickrichtung auf den Aufnahmebereich 8 ausgerichtet. Die Kamera 14 ist an einem Schwenkmechanismus befestigt, so dass die Kamera aus dem Zwischenraum zwischen der Andruckplatte 9 und dem Grundkörper 7 geschwenkt werden kann (in Richtung des Doppelpfeils 15).

Der Paralleltester 2, die Kamera 14 und der Fingertester 3 sind jeweils mit einer Steuereinrichtung 16 elektrisch verbunden, die die Bewegungen der einzelnen Geräte und die Fördereinrichtung 4 steuert.

Der Fingertester 3 weist einen an sich bekannten Aufbau auf, mit einem Grundkörper 17, zumindest einer Traverse 18, an welcher zwei Kontaktfinger 19 verfahrbar gelagert sind. Die Traverse 18 kann auf dem Grundkörper 17 parallel zur Förderrichtung 6 hin und her verfahren werden. An Stelle einer beweglichen Traverse können auch mehrere Traversen mit zusätzlichen Kontaktfingern vorgesehen sein. Im vorliegenden Ausführungsbeispiel ist der Fingertester lediglich zum Prüfen einer Seite einer zu testenden Leiterplatte ausgebildet. Es sind jedoch Fingertester bekannt, die zum beidseitigen Prüfen einer Leiterplatte ausgebildet sind. Derartige Fingertester können hier auch vorgesehen werden.

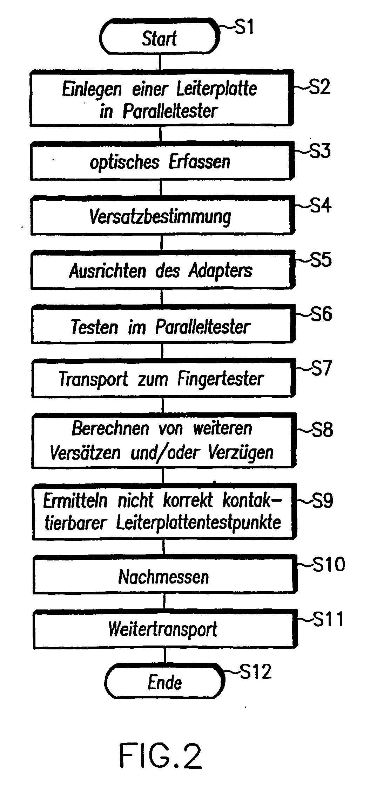

Das erfindungsgemäße Verfahren zum Testen einer Leiterplatte ist in Fig. 2 in Form eines Flußdiagrammes dargestellt. Das Verfahren beginnt mit dem Schritt S1. Hierbei wird eine einzelne Leiterplatte von der Fördereinrichtung 4 dem Paralleltester 2 zugeführt. Die Leiterplatte wird in den Aufnahmebereich 8 des Paralleltesters eingelegt (Schritt S2). Mit der Kamera 14 wird die Leiterplatte optisch abgetastet, wobei ein digitales Bild der Leiterplatte erstellt wird (Schritt S3). Vorzugsweise wird auch ein Abschnitt des Aufnahmebereichs 8 um die Leiterplatte optisch abgetastet, wobei in diesem Abschnitt Markierungen vorgesehen sind, so dass die Lage der Leiterplatte gegenüber dem Paralleltester mit entsprechendem Auswerteverfahren ermittelt werden kann.

Das von der Kamera 14 erfasste digitale Bild wird in der Steuereinrichtung 16 ausgewertet, wobei zunächst die Lage der Leiterplatte im Aufnahmebereich 8 und ein linearer Versatz der Leiterplattentestpunkte auf Grund von fertigungstechnischen Abweichungen beim Herstellen der Leiterplatte bestimmt werden (Schritt S4). Anhand der Lage der Leiterplatte bzw. dem ermittelten linearen Versatz der Leiterplattentestpunkte wird die Andruckplatte 9 in der X- und Y-Richtung ausgerichtet (Schritt S5). Unmittelbar vor oder nach dem Ausrichten der Andruckplatte wird die Kamera 14 aus dem Zwischenbereich zwischen der Andruckplatte 9 und dem Grundkörper 7 herausgeschwenkt, so dass die Andruckplatte 9 mit ihrem Adapter auf die im Aufnahmebereich 8 befindliche Leiterplatte abgesenkt und dagegen gedrückt werden kann. Die Leiterplatte wird in an sich bekannter Weise im Paralleltester getestet (Schritt S6).

Die im Paralleltester getestete Leiterplatte wird vom Paralleltester 2 zum Fingertester 3 befördert (Schritt S7).

Mit der Steuereinrichtung 16 werden Abweichungen der Leiterplattentestpunkte bezüglich ihrer Idealposition auf Grund von Versätzen und/oder Verzerrungen berechnet (Schritt S8).

Im Schritt S9 wird auf Grund des bzw. der im Schritt S4 ermittelten linearen Versätze bzw. Winkelversätze und falls im Schritt S8 Verzerrungen ermittelt worden sind, bestimmt, welche Leiterplattentestpunkte der zu testenden Leiterplatte beim Testen im Paralleltester nicht korrekt kontaktierbar sind (Schritt S9). Als nicht korrekt kontaktierbare Leiterplattentestpunkte werden diejenigen beurteilt, die am unmittelbaren Randbereich des jeweiligen Leiterplattentestpunktes oder überhaupt nicht mit dem ihm zugeordneten Kontaktelement des Adapters kontaktiert worden sind. Da der Ort der einzelnen Kontaktelemente des Adapters präzise bekannt ist und da auf Grund der in den Schritten S4 und S8 ermittelten Versätze und Verzerrungen der zu testenden Leiterplatte die Abweichungen der einzelnen Leiterplattentestpunkte bzgl. ihrer Idealposition präzise bestimmbar sind, können die nicht korrekt kontaktierbaren Leiterplattentestpunkte berechnet werden. In der Regel sind weniger als 1% bis 5% aller Leiterplattentestpunkte als nicht korrekt kontaktierbar beurteilbar. Üblicherweise sind die nicht korrekt kontaktierbaren Leiterplattentestpunkte sehr kleine Leiterplattentestpunkte mit einer Fläche von z.B. 0,1 mm x 0,1 mm. Bei derart kleinen Flächen genügt eine Abweichung von der Idealposition von z.B. 30 $\mu$m, dass sie nicht mehr mit dem entsprechenden Kontaktelement des Adapters kontaktiert werden können.

Nur die Leiterbahnen, die mit den als nicht korrekt kontaktierbaren Leiterplattentestpunkten verbunden sind, und die mit diesen Leiterbahnen verbundenen Leiterplattentestpunkte werden im Fingertester 3 sequentiell nachgemessen (Schritt S10). Hierbei werden an sich von Fingertestern bekannte Messverfahren verwendet. Da jedoch nur eine geringe Anzahl von Leiterbahnen nachgemessen werden muss, ist die Verweildauer einer zu testenden Leiterplatten im Fingertester äußerst kurz im Vergleich zur Verweildauer beim Testen aller Leiterbahnen mit dem Fingertester, wie es bisher üblich war. Nach dem Testen im Fingertester werden die Leiterplatten abtransportiert (Schritt S11) und die defekten und nicht defekten Leiterplatten separat gestapelt. Mit dem Schritt S12 ist das Verfahren beendet.

Nachfolgend wird die Ermittlung der Versätze und/oder Verzerrungen näher erläutert:

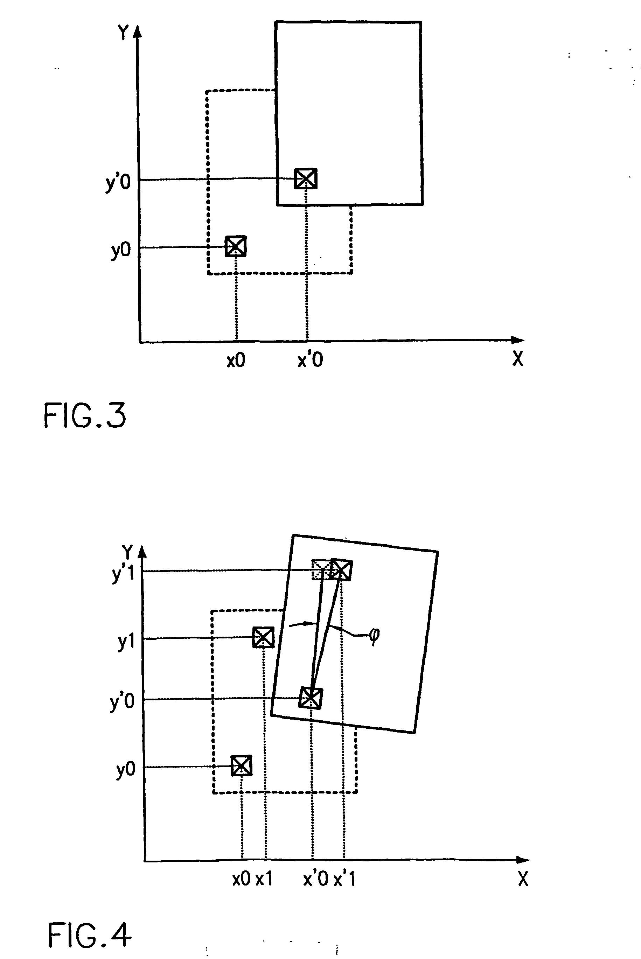

Zum Ermitteln eines linearen Versatzes genügt lediglich eine einzige Testmarkierung (Fig. 3). Beim Vergleichen der aus dem digital erfassten Bildes abgeleiteten Daten mit den Daten der ideal positionierten Leiterplatte wird ein Verschiebevektor v mit den Koordinaten a, b ermittelt, der sich von der Soll-Position bzw. Idealposition der Testmarkierung (x0, y0) zur Ist-Position der Testmarkierung (x'0, y'0) erstreckt. Dieser Verschiebevektor kann durch folgende Formeln berechnet werden:

$$a = x'0 - x0$$

$$b = y'0 - y0$$

Die Koordinaten der einzelnen Leiterplattentestpunkte werden dann gemäß der folgenden Formeln transformiert:

$$x' = x + a$$

$$y' = y + b$$

Soll neben dem linearen Versatz ein Winkelversatz ermittelt werden, so sind zumindest zwei Testmarkierungen der zu testenden Leiterplatte notwendig (Fig. 4). Diese Testmarkierungen besitzen in den Idealpositionen die Koordinaten x0, y0 bzw. x1, y1. In der Soll-Position der Leiterplatte besitzen diese Testmarkierungen die Koordinaten x'0, y'0 bzw. x'1, y'1. Die Berechnung des linearen Versatzes wird beispielsweise wie oben erläutert anhand der Testmarkierung mit den Koordinaten x0, y0 bzw. x'0, y'0 berechnet. Zur Berechnung des Winkelversatzes wird der Winkel $\varphi$ zwischen der Verbindungslinie der beiden Testmarkierungen der Leiterplatte in der Idealposition und der Verbindungslinie der beiden Testmarkierungen der Leiterplatte in der Ist-Position ermittelt. Der Winkel kann mit einfachen trigonometrischen Formel aus den jeweiligen Koordinate berechnet werden.

Die Koordinaten der Soll-Leiterplattentestpunkte werden dann gemäß folgenden Formeln in die Koordinaten der Ist-Leiterplattentestpunkte transformiert:

$$x' = x\cos\varphi + y\sin\varphi + a$$

$$y' = -x\sin\varphi + y\cos\varphi + b$$

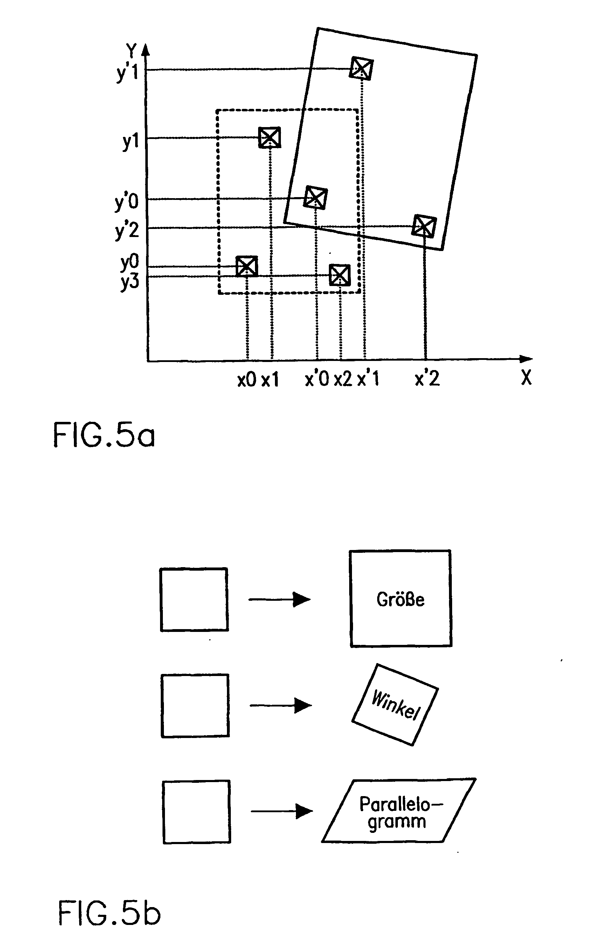

Besitzen die zu testenden Leiterplatten zumindest drei Testmarkierungen (Fig. 5a) so können zusätzlich zu einem linearen Versatz und einem Winkelversatz Verzerrungen der Leiterplatte kompensiert werden.

Die Koordinaten der Leiterplattentestpunkte werden gemäß folgender Formeln transformiert:

$$x' = a11x + a12y + a13$$

$$y' = a21x + a22y + a23$$

Die Koeffizienten aij werden erhalten durch Lösen eines linearen Gleichungssystems, das man aus den idealen und realen Positionen der Testmarkierungen erhält. Eine derartige Koordinatentransformation kann eine Größenänderung der Leiterplatte und eine Verformung einer rechteckigen Leiterplatte in ein Parallelogramm mit sich vom rechten Winkel unterscheidenden Winkeln kompensieren (Fig. 5b). Diese Verzerrungen sind lineare Verzerrungen. Das heißt, dass mit zumindest drei Testmarkierungen ein Linearversatz, ein Winkelversatz und lineare Verzerrungen kompensiert werden können.

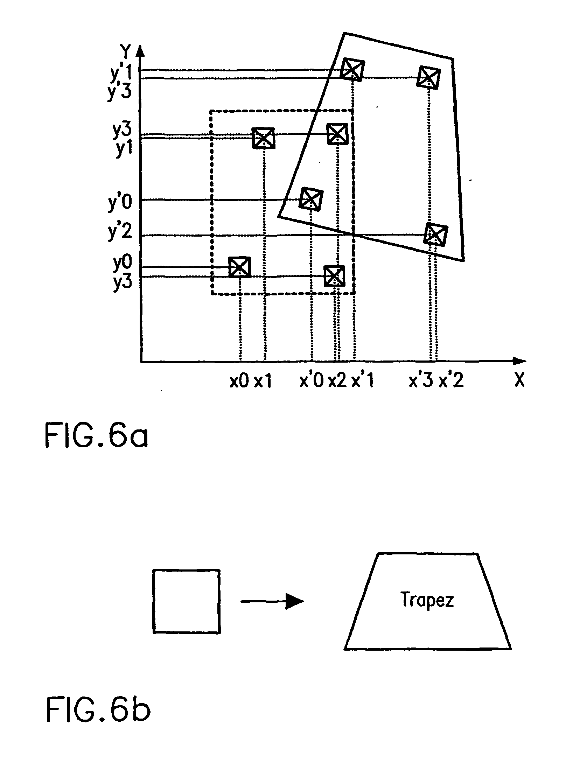

Zur Kompensation von nicht-linearen Verzerrungen sind zumindest vier Testmarkierungen notwendig (Fig. 6a). Die Koordinatentransformation erfolgt nach folgenden Formeln:

$$x' = a11x + a12y + a13xy + a14$$

$$y' = a21x + a22y + a23xy + a24$$

Die Koeffizienten aij werden erhalten durch Lösen eines linearen Gleichungssystems, das man aus den idealen und realen Positionen der Testmarkierungen erhält. Gegenüber dem Verfahren mit drei Testmarkierungen können zusätzlich nicht-lineare Verzerrungen kompensiert werden, mit welchen eine rechteckförmige Leiterplatte in eine trapezförmige Leiterplatte verformt wird (Fig. 6b). Derartige Verformungen können bei der Herstellung von Leiterplatten auftreten. Zur Verdeutlichung sind in Fig. 6a und 6b die Verzerrungen übertrieben dargestellt.

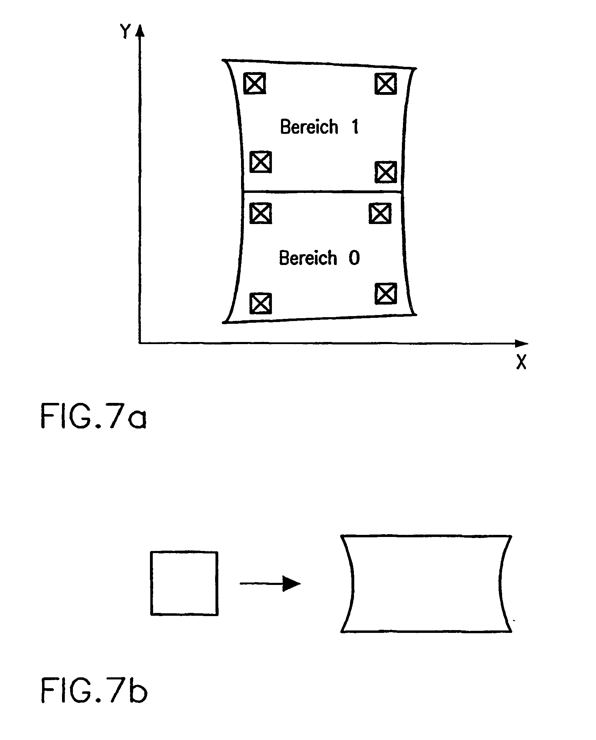

Verzerrungen auf Grund von Einschnürrungen können kompensiert werden, wenn die zu testende Leiterplatte in einzelne Bereiche (Bereich 0, Bereich 1) unterteilt werden (Fig. 7a), in welchen jeweils zumindest vier Testmarkierungen angeordnet sind. Die Testmarkierungen befinden sich vorzugsweise in Eckbereichen der jeweiligen Teilbereiche. Die Koordinatentransformation der einzelnen Teilbereiche erfolgt nach den obigen Formeln für vier Testmarkierungen. Fig. 7b zeigt schematisch eine entsprechende Einschnürung.

Es kann auch zweckmäßig sein, mehrere Leiterplatten gleichzeitig zu testen. Diese Leiterplatten werden gleichzeitig von der Kamera erfasst, wobei die Testmarkierungen der einzelnen Leiterplatten unabhängig voneinander kompensiert werden. Hierzu wird das von der Kamera 14 erfasste digitale Bild in z.B. drei Bereiche (Bereich 0, Bereich 1, Bereich 2) unterteilt. In den einzelnen Bereichen werden die darin befindlichen Testmarkierungen separat analysiert. Im vorliegenden Fall weisen die einzelnen Leiterplatten jeweils drei Testmarkierungen auf.

Mit den oben erläuterten Verfahren zur Kompensation von Versätzen und/oder Verzerrungen können die Ist-Koordinaten der Leiterplattentestpunkte aus den Soll-Koordinaten berechnet werden. Hierdurch werden die Abweichungen der Leiterplattentestpunkte gegenüber ihrer Idealposition berechnet. Die oben erläuterten Kompensationsverfahren können bei Leiterplatten angewendet werden, deren Leiterplattentestpunkte als Kupferbeschichtung auf die Oberfläche der Leiterplatte aufgebracht wird. Da eine solche Kupferbeschichtung den oben beschriebenen Versätzen und Verzerrungen unterliegen kann, können mit diesen Verfahren die hierdurch erzeugten Abweichungen korrekt berechnet werden.

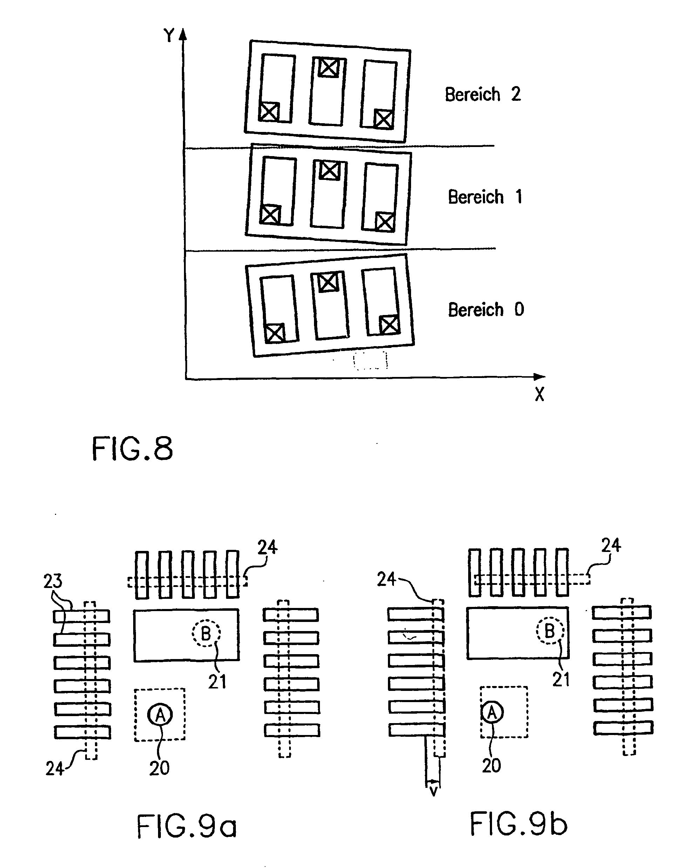

Ist jedoch der Leiterplatte zusätzlich ein Lötstoplack aufgetragen, der Kupferflächen bereichsweise abdeckt, so ist die Form einzelner Leiterplattentestpunkte durch den Lötstoplack begrenzt. Fig. 9a zeigt schematisch einen Ausschnitt einer Leiterplatte, wobei die Begrenzungslinien der Kupferflächen mit durchgehenden Linien dargestellt sind. Diese Leiterplatte ist mit einem Lötstoplack versehen. Dieser Lötstoplack weist Ausnehmungen auf, die in Fig. 9 mit Strichlinien dargestellt sind. Die einzelnen Leiterplattentestpunkte werden somit durch die Kupferflächen dargestellt, die sich innerhalb der Ausnehmungen des Lötstoplackes befinden.

Grundsätzlich unterscheidet man zwischen drei Typen von Leiterplattentestpunkten. Der übliche und deshalb als Standardleiterplattentestpunkt 20 bezeichnete Leiterplattentestpunkt ist aus einer Kupferfläche ausgebildet, die ein Stück kleiner als die die Kupferfläche umgebende Ausnehmung des Lötstoplackes ist. Der hierzu komplementäre Leiterplattentestpunkt, der Lötstoplack-begrenzte-Leiterplattentestpunkt 21, ist durch eine kleine Ausnehmung des Lötstoplackes auf einer größeren Kupferfläche ausgebildet. Dieser Leiterplattentestpunkt 21 wird alleine durch den Rand der Ausnehmung des Lötstoplackes festgelegt.

Sehr kleinflächige Leiterplattentestpunkte können einfach als sogenannte gemischte Leiterplattentestpunkte 22 hergestellt werden, wobei ein oder mehrere dünne Kupferstreifen 23 auf der Leiterplatte aufgebracht werden. Diese Kupferstreifen werden mit Lötstoplack abgedeckt, wobei eine schmale streifenförmige Ausnehmung 24, die quer zu den Kupferstreifen 23 verläuft, in den Lötstoplack eingebracht wird. Durch diese Ausnehmung 24 werden die Kupferstreifen 23 jeweils an einem durch die Breite der Ausnehmung 24 vorbestimmten Bereich freigelegt. Nur in diesem freigelegten Bereich können die Kupferstreifen 23 kontaktiert werden, so dass diese von den Ausnehmungen 24 freigelegten Bereichen 23 die gemischten Leiterplattentestpunkte bilden.

Da die Kupferbeschichtung und der Lötstoplack mit unterschiedlichen Herstellungsschritten auf die Leiterplatte aufgebracht werden, können sie auch unterschiedlichen Versätzen bzw. Verzerrungen unterliegen. Fig. 9b zeigt z.B. den Ausschnitt der Leiterplatte aus Fig. 9a, wobei der Lötstoplack um den Vektor v (horizontal nach rechts gerichtet in Fig. 9b) verschoben ist. Sofern sich der Standardleiterplattentestpunkt 20 innerhalb der entsprechenden Ausnehmung des Lötstoplackes befindet, bewirkt eine Verschiebung des Lötstoplackes auf der Leiterplatte keine Verschiebung des Standardleiterplattentestpunktes 20. Der Lötstoplack begrenzte Leiterplattentestpunkt 21 wird, durch die Verschiebung des Lötstoplackes entsprechend um den Vektor v verschoben.

Durch die Verschiebung des Lötstoplackes ergibt sich jedoch bei den gemischten Leiterplattentestpunkten 22 eine unterschiedliche Situation, je nachdem, wie die entsprechenden Ausnehmungen 24 bezüglich des Verschiebevektors v ausgerichtet sind. Ist die Längserstreckung der Ausnehmung 24 parallel zum Verschiebevektor v, so ergibt sich keine Veränderung in der Position der gemischten Leiterplattentestpunkte 22. Bildet die Längserstreckung der Ausnehmung 24 jedoch einen Winkel mit dem Verschiebevektor v so werden durch die Verschiebung des Lötstoplackes auch die durch die entsprechende Ausnehmung 24 begrenzten Leiterplattentestpunkte 22 verschoben. Ist die Längsrichtung der Ausnehmung 24 quer zum Verschiebevektor v, so entspricht die Verschiebung der entsprechenden Leiterplattentestpunkte dem Verschiebevektor.

Sind an einer Leiterplatte Leiterplattentestpunkte, die sowohl vom Lötstoplack begrenzt werden als auch unabhängig vom Lötstoplack sind, so muss zur Ermittlung einer korrekten Abweichung der einzelnen Leiterplattentestpunkte gegenüber ihrer Idealpositionen sowohl die Versätze und Verzerrungen des Lötstoplackes als auch die Versätze und Verzerrungen der Kupferbeschichtung berücksichtigt werden. Dies kann beispielsweise dadurch realisiert werden, dass ein Satz Testmarkierungen vorgesehen werden, die wie die Standardleiterplattentestpunkte 20 hergestellt sind oder Standardleiterplattentestpunkte 20 sind und deren Auswertung die Versätze und/oder Verzerrungen der Kupferschicht wiedergibt. Ein weiterer Satz Testmarkierungen ist wie die Lötstoplack begrenzten Testpunkte 21 ausgebildet oder wird durch Lötstoplack begrenzte Leiterplattentestpunkte 21 dargestellt. Die Analyse dieses weiteren Satzes Testmarkierungen ergibt die Versätze und/oder Verzerrungen des Lötstoplackes.

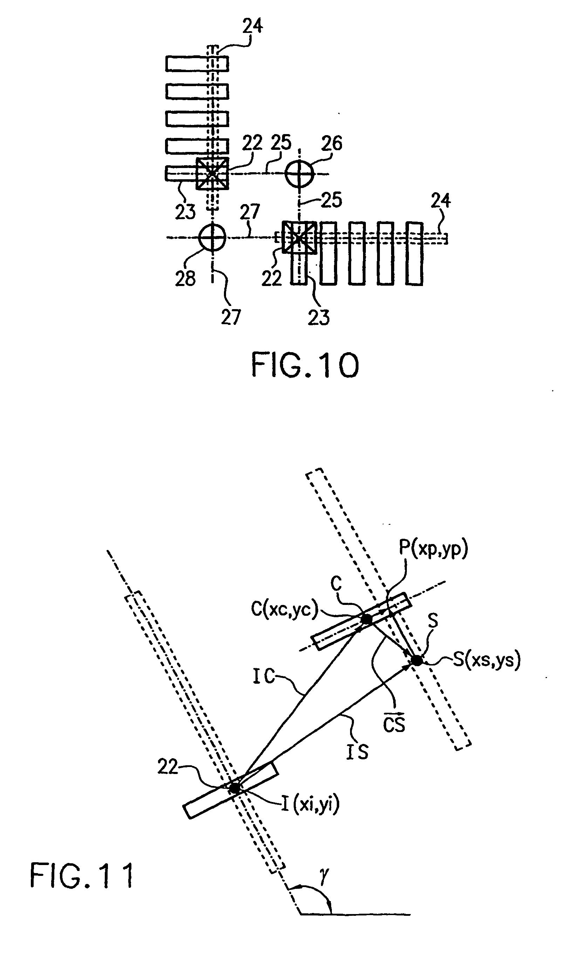

Es können jedoch auch gemischte Leiterplattentestpunkte 22 als Kennmarkierung verwendet werden (Fig. 10). Diese gemischten Leiterplattentestpunkte 22 können jedoch nicht unmittelbar zum Ermitteln der Versätze und Verzerrungen der Kupferschicht bzw. des Lötstoplackes eingesetzt werden, sondern ein in der Regel gemischter Leiterplattentestpunkt 22 muss bei einer Abweichung von der Idealposition bezüglich einer Verschiebung des Lötstoplackes und der Kupferbeschichtung ausgewertet werden.

Vorzugsweise werden zwei benachbarte gemischte Leiterplattentestpunkte 22 zur Ermittlung der Abweichungen verwendet, wobei diese gemischten Leiterplattentestpunkte 22 jeweils aus senkrecht zueinander angeordneten Kupferstreifen 23 und zueinander senkrecht angeordneten streifenförmigen Ausnehmungen 24 im Lötstoplack bestehen. In Fig. 10 sind die geradlinigen Verlängerungen 25 der Längserstreckungen der Kupferstreifen 23 eingezeichnet. Diese Linien 25 schneiden sich an einer virtuellen Testmarkierung 26. Die streifenförmigen Ausnehmungen 24 des Lötstoplackes sind mit weiteren geraden Linien 27 verlängert, die sich an einer virtuellen Testmarkierung 28 kreuzen. Bei einer Verschiebung der Leiterplattentestpunkte 22 können die Verschiebungen der Linien 25, 27 entsprechend ermittelt werden, wodurch eine entsprechende Verschiebung der virtuellen Testmarkierung 26, 28 bestimmt ist. Die Linien 25 der beiden Leiterplattentestpunkte 22 stellen die Verschiebung der Kupferschicht in zwei zueinander senkrechten Richtungen dar, womit die Verschiebung der Kupferschicht in den Bereich dieser beiden Leiterplattentestpunkte 22 vollständig beschrieben ist. Entsprechendes gilt für die Linien 27, die die Verschiebung des Lötstoplackes in diesem Bereich vollständig darstellen. Die Ermittlung der Koordinaten der virtuellen Leiterplattentestpunkte beschreibt somit für diesen Bereich der Leiterplatte die Verschiebung der Kupferschicht sowie die Verschiebung des Lötstoplackes. Die oben erläuterten Verfahren zum Ermitteln der Abweichungen der Leiterplattentestpunkte mit einer bis vier Testmarkierungen können dahingehend abgewandelt werden, dass an Stelle der einzelnen Testmarkierungen jeweils Paare von gemischten Leiterplattentestpunkten verwendet werden, die an den entsprechenden Bereichen jeweils die Verschiebung des Lötstoplackes und der Kupferbeschichtung wiedergeben.

Sind die Versätze und Verzerrungen der Kupferschicht und des Lötstoplackes ermittelt, so können aus den Idealkoordinaten des Punktes $I(x_i, y_i)$ der Idealposi-

tion eines gemischten Leiterplattentestpunktes 22 die Kupferkoordinaten des Punktes C(xc, yc), die der Verschiebung durch die Kupferschicht entsprechen, und die Lötstoplackkoordinaten des Punktes S(xs, ys), die der Verschiebung des Lötstoplackes entsprechen, nach folgenden Formeln ermittelt werden:

$$Xc=a11x+a12y+a13xy+a14$$

$$Yc=a21x+a22y+a23xy+a24$$

$$Xs=b11x+b12y+b13xy+b14$$

$$Ys=b21x+b22y+b23xy+b24$$

Die Vektoren **IC** und **IS,** die sich jeweils von dem durch die Idealkoordinaten beschriebenen Leiterplattentestpunkt I zu den durch die Kupferkoordinaten bzw. Lötstoplackkoordinaten beschriebenen Punkten C, S erstrecken, geben jeweils die Verschiebung des Kupferstreifens bzgl. seiner Idealposition bzw. der streifenförmigen Ausnehmung bzgl. ihrer Idealposition an. Ein Differenzvektor **CS** der beiden Vektoren **IC, IS** erstreckt sich vom Punkt C bis zum Punkt S. Projiziert man den Vektor **CS** auf die Längsrichtung des Kupferstreifens 23 und addiert man den derart projizierten Vektor zum Punkt C, so erhält man die sich durch die Versätze und Verzerrungen der Kupferschicht und des Lötstoplackes ergebene Verschiebung bzw. Abweichung des Ist-Leiterplattentestpunktes P gegenüber der Idealposition I des Leiterplattentestpunktes. Die Koordinaten des Punktes P können selbstverständlich auch durch Projektion des Vektors **CS** auf die Längsrichtung des Ausnehmung 24 und der entsprechenden Vektorsubtraktion vom Punkt S erhalten werden.

Aus obigem kann man erkennen, dass folgende Angaben zum Berechnen der Abweichungen von gemischten Leiterplattentestpunkten notwendig sind:

- Der Versatz bzw. die Versätze und/oder Verzerrungen der Kupferschicht,
- der Versatz bzw. die Versätze und/oder Verzerrungen des Lötstoplackes, und
- die Richtung des jeweiligen Kupferstreifens oder der streifenförmigen Ausnehmung der Lötstopmaske.

Sind diese Angaben vorhanden, so können die Abweichungen der gemischten Leiterplattentestpunkte berechnet werden.

In Abhängigkeit des Leiterplattentyps wird eines der oben erläuterten Verfahren zum Berechnen der Abweichungen verwendet. Dieses Verfahren kann mit einer einzigen Testmarkierung arbeiten oder die Leiterplatten können auch in mehrere Teilbereiche unterteilt werden, in welchen bis zu vier Paar Testmarkierungen vorgesehen sind.

Die Berücksichtigung des Lötstoplacks zum Bestimmen der Abweichung eines Leiterplattentestpunktes gegenüber seiner Idealposition stellt einen eigenständigen Erfindungsgedanken dar, der auch in anderen Anwendungen zum Prüfen von Leiterplatten eingesetzt werden kann. So kann diese Art der Bestimmung der Abweichung z.B. zum Ausrichten einer Leiterplatte in einem Paralleltester oder zum Bestimmen der Koordinaten des Leiterplattentestpunktes in einem Fingertester verwendet werden, wodurch die Kontaktfinger jeweils korrekt auf dem Leiterplattentestpunkt positioniert werden.

Die Erfindung ist oben anhand eines Ausführungsbeispiels erläutert, bei dem die als nicht sicher korrekt kontaktierbar bewerteten Leiterplattentestpunkte, da sie derart stark von ihrer Idealposition abweichen, dass die Gefahr besteht, dass sie nicht mehr korrekt von den in der Idealposition angeordneten Kontaktelementen des Paralleltesters kontaktiert werden, nachgemessen werden.

Im Rahmen der Erfindung können jedoch alle Leiterplattentestpunkte und die damit verbundenen Leiterbahnen nachgemessen werden, die als nicht korrekt kontaktierbar zu bewerten sind oder die grundsätzlich nicht kontaktierbar sind.

Grundsätzlich nicht kontaktierbar sind z.B. Leiterplattentestpunkte, für welche am Paralleltester keine entsprechenden Kontaktelemente vorgesehen sind. Das Weglassen von Kontaktelementen am Paralleltester ist für folgende Gruppen von Leiterplatten zweckmäßig:

- Es gibt Leiterplattentestpunkte, die sogenannten Bondpads, an welchen möglichst keine Nadelabdrücke einer Kontaktnadel eines Paralleltesters eingebracht werden sollen. Da die Prüfnadeln eines Paralleltesters mit einem erheblichen Druck (entspricht z.B. dem Gewicht von 30 g bis 100 g) auf die Leiterplattentestpunkte drücken, kann es insbesondere bei kleinen Leiterplattentestpunkten sein, dass diese derart beschädigt werden, dass eine nachfolgende Befestigung eines Leiterelementes nicht möglich ist. Am Adapter des Paralleltesters werden keine Prüfnadeln für diese "sensiblen" Leiterplattentestpunkte vorgesehen, so dass sie mit dem Paralleltester nicht kontaktiert und damit nicht getestet werden.

- Bei hoher Prüfpunktdichte können in einem Bereich alle Kontaktpunkte des Paralleltesters belegt sein, obwohl noch nicht alle Leiterplattentestpunkte kontaktiert sind. In solchen Bereichen gibt es keine freien Prüfnadeln des Paralleltesters, so dass zwangsläufig gewisse Leiterplattentestpunkte nicht kontaktiert werden können.

Als nicht sicher korrekt kontaktierbar müssen folgende Gruppen von Leiterplatten bewertet werden:

- Es gibt die oben ausführlich erläuterten Leiterplattentestpunkte, die derart stark von ihrer Idealposition abweichen, dass die Gefahr besteht, dass sie nicht mehr korrekt von den in der Idealposition angeordneten Kontaktelementen (Prüfnadeln) des Paralleltesters kontaktiert werden.
- Es gibt auch Leiterplattentestpunkte, die kleiner (z.B. mit einem Durchmesser von 100 $\mu$m) als die Spezifikation der Kontaktelemente (Genauigkeit von z.B. 200 $\mu$m) sind. Bei derart kleinen Leiterplattentestpunkten besteht grundsätzlich die Gefahr, dass sie von den Kontaktelementen des Paralleltesters nicht korrekt kontaktiert werden. Es kann zweckmäßig sein, diese Leiterplattentestpunkte generell nicht mit dem Paralleltester zu messen. Dies gilt insbesondere für unbelegte, d.h. nicht mit einer Leiterbahn verbundene Leiterplattentestpunkte, die lediglich zum Befestigen von elektronischen Bauteilen dienen. Diese können sehr einfach, schnell und sicher optisch nachgemessen werden.

Oben wurde die Erfindung anhand einer Ausführungsform mit einem Fingertester beschrieben. An Stelle eines Fingertesters, der durch Berührung die einzelnen Leiterplattentestpunkte kontaktiert, können auch sequentielle Testverfahren verwendet werden, bei welchem die einzelnen Leiterplattentestpunkte mittels Laser-, Plasma- oder Elektronenstrahltestverfahren kontaktiert werden. An Stelle eines elektrischen Verfahrens zum Nachmessen der nicht korrekt kontaktierbaren Leiterplattentestpunkte kann auch ein optisches Testverfahren verwendet werden.

Beim oben beschriebenen Ausführungsbeispiel werden die Abweichungen der Leiterplattentestpunkte von ihrer Idealposition mittels einer optischen Messung ermittelt. Im Rahmen der Erfindung ist es auch möglich, derartige Abweichungen mittels einer elektrischen Messung zu ermitteln. Diesbezüglich wird bspw. auf die EP 0 874 243 A2 verwiesen, in der entsprechende Abweichungen von der Soll-Position elektrisch gemessen werden. Die EP 0 874 243 A2 wird unter Bezugnahme in die vorliegende Anmeldung inkorperiert.

So ist es im Rahmen der Erfindung möglich, durch eine logische Kombination der Kontaktzustände einiger Kontäktnadeln mit Kontaktpunkten der zu testenden Leiterplatte Versätze, Verschiebungen und dgl. zu ermitteln. Die Kontaktpunkte können Leiterplattentestpunkte oder spezielle elektrisch leitende Markierungen sein.

Bei diesem elektrischen Testverfahren zum Ermitteln von Abweichungen ist von Vorteil, dass es mit den Testnadeln eines Adapter oder wenigen zusätzlichen Testnadeln, die in den Adapter integrierbar sind, ausführbar und im Wesentlichen gleichzeitig mit den Messungen auf Unterbrechung und Kurzschluss der Netze durchführbar ist.

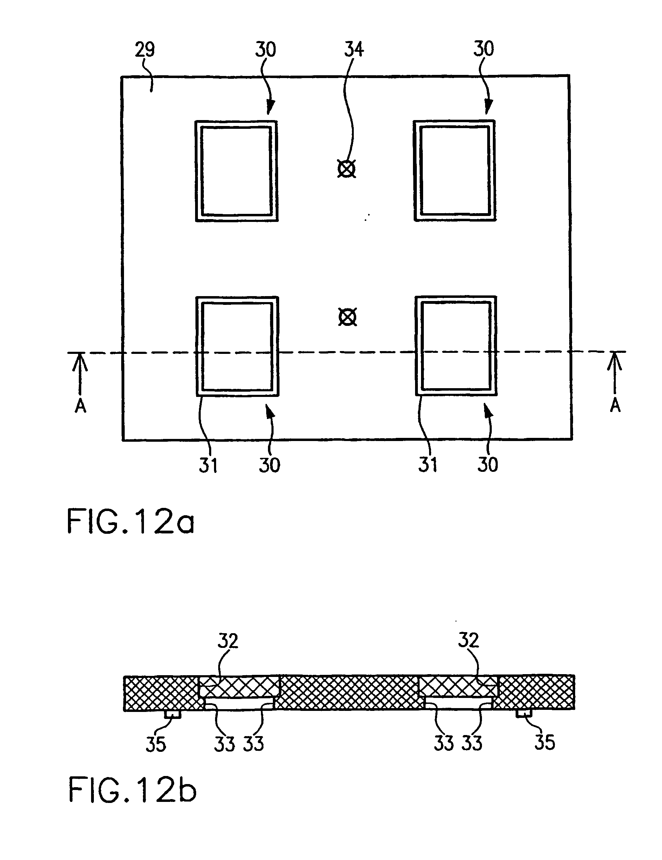

Fig. 12a und 12b zeigen eine Draufsicht bzw. einen Schnitt durch eine Halteplatte 29. Die Halteplatte 29 ist eine Kunststoffplatte mit mehreren Ausnehmungen. Im vorliegenden Beispiel weist die Halteplatte 29 vier Ausnehmungen 30 auf, die der Form der zu testenden Leiterplatten entsprechen. Die Ausnehmungen 30 weisen jeweils einen Begrenzungsrand 31 auf, der im dargestellten Ausführungsbeispiel durch eine vertikal verlaufende Begrenzungswandung 32 und einem am Begrenzungsrand 13 umlaufenden Vorsprung 33 dargestellt ist, wobei der Vorsprung 33 unterhalb der Begrenzungswandung 32 einstückig an der Halteplatte derart ausgebildet ist, dass er mit der unteren Seitenfläche der Halteplatte 29 bündig abschließt.

Die Begrenzungswandung 32 einer Ausnehmung 30 ist exakt der Form einer zu testenden Leiterplatte angepasst, so dass diese formschlüssig in der Ausnehmung 30 aufnehmbar ist und durch den Vorsprung 33, der als Halterelement dient, gegen ein Herausfallen aus der Ausnehmung 30 gesichert ist. Die Ausnehmung kann auch nicht formschlüssig ausgebildet sein, wobei dann die Leiterplatte bspw. mittels eines Klebebandes ortsfest an der Halteplatte fixiert wird.

An der Oberseite der Halteplatte sind optische Markierungen 34 aufgebracht, anhand derer bei der optischen Erfassung der Halteplatte mit den darin eingelegten Leiterplatten die Position der Leiterplatten bzgl. des Halteplatte eindeutig festlegbar ist. An der Unterseite der Halteplatte sind elektrische Kontakte 35 angebracht, die zur Detektion der Lage der Halteplatte im Paralleltester und im sequentiellen Tester dienen.

Mit einer solchen Halteplatte können die Leiterplatten an einer unabhängig vom Paralleltester ausgebildeten Messstation mit einer Kamera optisch abgetastet werden. Anhand des so erfassten digitalen Bildes kann dann beim Weitertransport der Halteplatte 29 in den Paralleltester und in der nachfolgenden Testeinrichtung die Lage der Leiterplatten und die Koordinaten der einzelnen abzutastenden Leiterplattentestpunkte eindeutig bestimmt werden, sofern die Lage der Halteplatte im Paralleltester bzw. in der nachfolgenden Testeinrichtung eindeutig bestimmbar ist. Da die Halteplatte an der Unterseite mit den Kontakten 35 versehen ist, die mittels in den Paralleltester bzw. in der nachfolgenden Testeinrichtung integrierten Kontaktelementen abgetastet werden, kann die Lage der Halteplatte in den beiden Teststationen eindeutig festgelegt und gegebenenfalls in an sich bekannter Weise ausgerichtet werden. Hierdurch sind die Koordinaten der Leiterplattentestpunkte bzgl. des Paralleltesters und der nachgeschalteten Testeinrichtung eindeutig festgelegt.

Die Erfindung ist oben anhand von Ausführungsbeispielen erläutert worden, welche lediglich an einer Seite der zu testenden Leiterplatte eine Nachmessung ausführen. Dies ist bei Leiterplattentypen zweckmäßig, die nur auf einer Seite Leiterplattentestpunkte in hoher Leiterplattentestpunktdichte aufweisen. Auf der Seite der Leiterplatte, die nur mit Kontaktpunkten in geringerer Dichte versehen ist, sind die Leiterplattentestpunkte in der Regel so groß ausgebildet, dass es im Paralleltester zu keinen Fehlkontakten kommt. Für Leiterplattentypen, die beidseitig mit hoher Leiterplattentestpunktdichte ausgebildet sind, wird die erfindungsgemäße Vorrichtung dahingehend abgewandelt, dass beide Seiten sowohl im Paralleltester als auch in der nachgeschalteten Testeinrichtung nachgemessen werden. Hierzu ist es zweckmäßig, auch beide Seiten z.B. optisch nachzumessen.

**Patentansprüche**

1. Verfahren zum Prüfen von Leiterplatten mit einem Paralleltester, wobei die Leiterplatten Leiterbahnen aufweisen, deren Endpunkte als Leiterplattentestpunkte ausgebildet sind, die zum Testen kontaktiert werden können, wobei das Verfahren folgende Schritte umfasst:

   - Testen einer zu testenden Leiterplatte mit einem Paralleltester (2), wobei Leiterplattentestpunkte der zu testenden Leiterplatte mit Kontaktelementen des Paralleltesters in Kontakt gebracht werden,
   - Bestimmen von Leiterplattentestpunkten, die entweder als nicht sicher korrekt mit den Paralleltester kontaktierbar beurteilbar sind oder die grundsätzlich mit dem Paralleltester nicht kontaktierbar sind, und
   - Nachmessen der als nicht sicher korrekt kontaktierbar beurteilbaren Leiterplattentestpunkte bzw. der nicht kontaktierbaren Leiterplattentestpunkte und den damit verbundenen Leiterbahnen mit einer von den Kontaktelementen des Paralleltesters unabhängigen Einrichtung (3).

2. Verfahren nach Anspruch 1,
   **dadurch gekennzeichnet,**
   **dass** Abweichungen der Leiterplattentestpunkte gegenüber ihrer Idealposition ermittelt werden, wobei die Leiterplattentestpunkte als nicht korrekt beurteilt werden, die aufgrund ihrer Abweichung von der Idealposition nicht sicher korrekt mit den Kontaktelementen des Paralleltesters (2) in Kontakt gebracht werden können.

3. Verfahren nach Anspruch 1 oder 2,
   **dadurch gekennzeichnet,**
   **dass** das Nachmessen mittels eines Fingertesters (3) erfolgt.

4. Verfahren nach einem der Ansprüche 1 bis 3,
   **dadurch gekennzeichnet,**
   **dass** das Nachmessen mittels eines optischen Testverfahrens erfolgt.

5. Verfahren nach einem der Ansprüche 1 bis 4,
   **dadurch gekennzeichnet,**
   **dass** das Nachmessen mittels eines Laser-, Plasma- oder Elektronenstrahltestverfahrens erfolgt.

6. Verfahren nach einem der Ansprüche 1 bis 5,
   **dadurch gekennzeichnet,**
   **dass** die Abweichungen der Leiterplattentestpunkte gegenüber ihrer Idealposition mittels eines optischen Testverfahrens oder mittels eines elektrischen Testverfahrens ermittelt werden.

7. Verfahren nach Anspruch 6,
   **dadurch gekennzeichnet,**
   **dass** zumindest die Position eines vorbestimmten Leiterplattentestpunktes und/oder einer an der Leiterplatte angeordneten Testmarkierung erfasst wird und aus der Abweichung dieser gemessenen Ist-Position bzw. der gemessenen Ist-Positionen von der Idealposition bzw. den Idealpositionen die Abweichungen der Leiterplattentestpunkte gegenüber ihren Idealpositionen berechnet werden.

8. Verfahren nach Anspruch 7,
   **dadurch gekennzeichnet,**
   **dass** die Position eines einzigen Leiterplattentestpunktes oder einer einzigen Testmarkierung erfasst wird, und aus den erfassten Koordinaten dieser Position die Abweichung der Leiterplattentestpunkte gegenüber ihrer Idealposition als ein linearer Versatz berechnet wird.

9. Verfahren nach Anspruch 7,
   **dadurch gekennzeichnet,**
   **dass** zwei Positionen von Leiterplattentestpunkten und/oder Testmarkierungen erfasst werden, und aus den erfassten Koordinaten dieser Positionen die Abweichungen der Leiterplattentestpunkte gegenüber ihrer Idealposition als linearer Versatz und als Winkelversatz berechnet werden.

10. Verfahren nach Anspruch 7,
   **dadurch gekennzeichnet,**
   **dass** drei Positionen von Leiterplattentestpunkten und/oder Testmarkierungen erfasst werden, und aus den erfassten Koordinaten dieser Positionen die Abweichungen der Leiterplattentestpunkte gegenüber ihrer Idealposition als linearer Versatz, als Winkelversatz und als Versatz durch eine lineare Verzerrung berechnet werden.

11. Verfahren nach Anspruche 7,
   **dadurch gekennzeichnet,**
   **dass** vier Positionen von Leiterplattentestpunkten und/oder Testmarkierungen erfasst werden, und aus den erfassten Koordinaten dieser Positionen die Abweichungen der Leiterplattentestpunkte gegenüber ihrer Idealposition als linearer Versatz, als Winkelversatz und als Versatz durch eine 2-dimensionale Verzerrung berechnet werden.

12. Verfahren nach einem der Ansprüche 7 bis 11, **dadurch gekennzeichnet,** **dass** von einer zu testenden Leiterplatte mehrere Bereiche erfasst werden, und die einzelnen Bereiche separat auf Abweichungen der Leiterplattentestpunkte bzgl. ihrer Idealposition ausgewertet werden.

13. Verfahren nach einem der Ansprüche 7 bis 12, **dadurch gekennzeichnet,** **dass** mehrere zu testende Leiterplatten gleichzeitig getestet werden und die mehreren zu testenden Leiterplatten gleichzeitig erfasst werden, um die Abweichungen der Leiterplattentestpunkte bzgl. ihrer Idealposition zu ermitteln.

14. Verfahren zur Ermittlung von Abweichungen für ein Verfahren nach einem der Ansprüche 2 bis 13, **dadurch gekennzeichnet,** **dass** zur Ermittlung der Abweichungen von Leiterplattentestpunkten gegenüber den jeweiligen Idealpositionen Versätze einer die Leiterplattentestpunkte ausbildenden Kupferbeschichtung unabhängig von Versätzen einer Lötstopplackbeschichtung ermittelt werden.

15. Verfahren nach Anspruch 14, **dadurch gekennzeichnet,** **dass** die Versätze der Kupferbeschichtung und die Versätze der Lötstopplackbeschichtung mittels jeweils voneinander unabhängigen Sätzen von Leiterplattentestpunkten bzw. Testmarkierungen ermittelt werden.

16. Verfahren nach Anspruch 14, **dadurch gekennzeichnet,** **dass** die Versätze der Kupferbeschichtung und die Versätze der Lötstopplackbeschichtung mittels eines Satzes gemischter Leiterplattentestpunkte bzw. Testmarkierungen ermittelt werden.

17. Verfahren nach einem der Ansprüche 1 bis 16, **dadurch gekennzeichnet,** **dass** der Paralleltester derart ausgebildet ist, dass für die grundsätzlich nicht kontaktierbaren Leiterplattentestpunkte keine entsprechenden Kontaktelemente vorgesehen sind.

18. Vorrichtung, insbesondere zum Ausführen eines Verfahrens nach einem der Ansprüche 1 bis 16, zum Prüfen von Leiterplatten, wobei die Leiterplatten Leiterbahnen aufweisen, deren Endpunkte als Leiterplattentestpunkte ausgebildet sind, die zum Testen kontaktiert werden können, umfassend:

- einen Paralleltester (2), der Kontaktelemente zum gleichzeitigen Kontaktieren von Leiterplattentestpunkten der zu testenden Leiterplatte aufweist,
- eine Einrichtung (16) zum Bestimmen von Leiterplattentestpunkten, die entweder als nicht sicher korrekt mit den Paralleltester kontaktierbar beurteilbar sind oder die grundsätzlich mit dem Paralleltester nicht kontaktierbar sind, und
- eine von den Kontaktelementen des Paralleltesters unabhängige Einrichtung (3) zum Nachmessen der Leiterplattentestpunkte und der damit verbundenen Leiterbahnen, wobei die Leiterplattentestpunkte entweder als nicht sicher korrekt mit den Paralleltester kontaktierbar beurteilbar sind oder grundsätzlich mit dem Paralleltester nicht kontaktierbar sind.

**Revendications**

1. Procédé pour contrôler des cartes à circuits imprimés avec un testeur parallèle, les cartes à circuits imprimés présentant des pistes conductrices dont les points terminaux sont réalisés sous formes de points de test de carte, lesquels peuvent être mis en contact pour le test, le procédé comprenant les étapes suivantes :

- tester une carte à circuits imprimés à tester avec un testeur parallèle (2), des points de test de carte imprimés de la carte à tester étant mis en contact avec des éléments de contact du testeur parallèle,
- déterminer des points de test de carte qui soit peuvent être jugés comme ne pouvant pas être mis en contact de manière sûrement correcte avec le testeur parallèle, soit ne peuvent fondamentalement pas être mis en contact avec le testeur parallèle, et
- contrôler la mesure aux points de test de carte qui peuvent être jugés comme ne pouvant pas être mis en contact de manière sûrement correcte ou aux points de test de carte qui ne peuvent pas être mis en contact et les pistes conductrices reliées à ceux-ci, avec un système (3) indépendant des éléments de contact du testeur parallèle.

2. Procédé selon la revendication 1, **caractérisé en ce que** on détermine des déviations des points de test de carte par rapport à leur position idéale, ce pourquoi on juge comme n'étant pas corrects les points de test de carte qui, en raison de leur déviation par rapport à la position idéale, ne peuvent pas être mis en contact de manière sûrement correcte avec les éléments de contact du testeur parallèle (2).

**3.** Procédé selon la revendication 1 ou 2, **caractérisé en ce que** le contrôle de mesure a lieu au moyen d'un testeur à doigt (3).

**4.** Procédé selon l'une des revendications 1 à 3, **caractérisé en ce que** le contrôle de mesure a lieu au moyen d'un procédé de test optique.

**5.** Procédé selon l'une des revendications 1 à 4, **caractérisé en ce que** le contrôle de mesure a lieu au moyen d'un procédé de test à faisceau laser, à faisceau de plasma ou à faisceau électronique.

**6.** Procédé selon l'une des revendications 1 à 5, **caractérisé en ce que** les déviations des points de test de carte imprimés par rapport à leur position idéale sont déterminés au moyen d'un procédé de test optique ou au moyen d'un procédé de test électrique.

**7.** Procédé selon la revendication 6, **caractérisé en ce que** l'on saisit au moins la position d'un point de test de carte prédéterminé et/ou d'une marque de test agencée sur la carte et, à partir de la déviation de cette position réelle mesurée ou des positions réelles mesurées par rapport à la position idéale ou aux positions idéales, on calcule les déviations des points de test de carte par rapport à leurs positions idéales.

**8.** Procédé selon la revendication 7, **caractérisé en ce que** l'on saisit la position d'un seul point de test de carte ou d'une seule marque de test, et à partir des coordonnées saisies de cette position, on calcule la déviation des points de test de carte par rapport à leur position idéale, en tant que décalage linéaire.

**9.** Procédé selon la revendication 7, **caractérisé en ce que** l'on saisit deux positions de points de test de carte et/ou de marques de test, et à partir des coordonnées saisies de cette position, on calcule la déviation des points de test de carte par rapport à leur position idéale, en tant que décalage linéaire et en tant que décalage angulaire.

**10.** Procédé selon la revendication 7, **caractérisé en ce que** l'on saisit trois positions de points de test de carte et/ou de marques de test, et à partir des coordonnées saisies de cette position, on calcule la déviation des points de test de carte par rapport à leur position idéale, en tant que décalage linéaire, en tant que décalage angulaire et en tant que décalage par distorsion linéaire.

**11.** Procédé selon la revendication 7, **caractérisé en ce que** l'on saisit quatre positions de points de test de carte et/ou de marques de test, et à partir des coordonnées saisies de cette position, on calcule la déviation des points de test de carte par rapport à leur position idéale, en tant que décalage linéaire, en tant que décalage angulaire et en tant que décalage par distorsion en deux dimensions.

**12.** Procédé selon l'une des revendications 7 à 11, **caractérisé en ce que** l'on saisit plusieurs régions d'une carte à tester, et les régions individuelles sont évaluées séparément du point de vue des déviations des points de test de carte par rapport à leur position idéale.

**13.** Procédé selon l'une des revendications 7 à 12, **caractérisé en ce que** l'on teste simultanément plusieurs cartes à tester et l'on saisit simultanément les plusieurs cartes à tester pour déterminer les déviations des points de carte par rapport à leur position idéale.

**14.** Procédé de détermination de déviations pour un procédé selon l'une des revendications 2 à 13, **caractérisé en ce que** pour déterminer les déviations de points de carte par rapport à leurs positions respectives idéales, on détermine des décalages d'un revêtement de cuivre constituant les points de test de carte indépendamment de décalages d'un revêtement de réserve de soudure.

**15.** Procédé selon la revendication 14, **caractérisé en ce que** les décalages du revêtement de cuivre et les décalages du revêtement de réserve de soudure sont déterminés au moyen de jeux, indépendants les uns des autres, de points de test de carte ou de marques de test.

**16.** Procédé selon la revendication 14, **caractérisé en ce que** les décalages du revêtement de cuivre et les décalages du revêtement de réserve de soudure sont déterminés au moyen d'un jeu de points de test de carte mélangés ou de marques de test mélangées.

**17.** Procédé selon l'une des revendications 1 à 16, **caractérisé en ce que** le testeur parallèle est réalisé de telle sorte que pour les points de test de carte qui ne peuvent fondamentalement pas être mis en contact, il n'est pas prévu d'éléments de contact correspondants.

**18.** Dispositif pour contrôler des cartes à circuits imprimés, en particulier pour mettre en oeuvre un procédé selon l'une des revendications 1 à 16, les cartes présentant des pistes conductrices dont les points terminaux sont réalisés sous forme de points de test de carte qui peuvent être mis en contact pour le test, comprenant :

- un testeur parallèle (2) qui présente des éléments de contact pour mettre simultanément en contact des points de test de la carte à tester,
- un système (16) pour déterminer des points de test de carte qui soit peuvent être jugés comme ne pouvant pas être mis en contact de manière sûrement correcte avec le testeur parallèle, soit ne peuvent fondamentalement pas être mis en contact avec le testeur parallèle, et
- un système (3) indépendant des éléments de contact du testeur parallèle, pour contrôler la mesure des points de test de carte et des pistes conductrices reliées à ceux-ci, et ici les points de test de carte sont soit ceux qui peuvent être jugés comme ne pouvant pas être mis en contact de manière sûrement correcte avec le testeur parallèle, soit ceux qui ne peuvent fondamentalement pas être mis en contact avec le testeur parallèle.

**Claims**

**1.** Method of testing printed circuit boards with a parallel tester, wherein the printed circuit boards have conductor paths, the end points of which are in the form of circuit board test points which may be contacted for testing, wherein the method comprises the following steps:

- testing of a printed circuit board to be tested with a parallel tester (2), wherein circuit board test points of the printed circuit board to be tested are brought into contact with contact elements of the parallel tester,
- determination of circuit board test points which are either judged to be incapable of reliable correct contacting by the parallel tester, or which can basically not be contacted by the parallel tester, and
- checking of the circuit board test points judged to be incapable of reliable correct contacting and of the circuit board test points which can not be contacted and the associated conductor paths, by a device (3) which is independent of the contact elements of the parallel tester.

**2.** Method according to claim 1,
**characterized in that** deviations of the circuit board test points from their ideal position are determined, with circuit board test points being judged to be incorrect if, on account of their deviation from the ideal position, they can not be correctly contacted with reliability by the contact elements of the parallel tester (2).

**3.** Method according to claim 1 or 2,
**characterized in that** checking is carried out using a finger tester (3).

**4.** Method according to one of the claims 1 to 3,
**characterized in that** checking is carried out by means of an optical method of testing.

**5.** Method according to one of the claims 1 to 4,
**characterized in that** checking is carried out using a laser, plasma or electron beam method.

**6.** Method according to one of the claims 1 to 5,
**characterized in that** the deviations of the circuit board test points from their ideal position are determined by means of an optical method of testing or by means of an electrical method of testing.

**7.** Method according to claim 6,
**characterized in that** at least the position of a predetermined circuit board test point and/or a test marking located on the printed circuit board is recorded, and the deviations of the circuit board test points from their ideal positions are calculated from the deviation of this measured actual position or measured actual positions from the ideal position or ideal positions.

**8.** Method according to claim 7,
**characterized in that** the position of a single circuit board test point or a single test marking is recorded and the deviation of the circuit board test points from their ideal position is calculated as a linear misalignment from the recorded coordinates of this position.

**9.** Method according to claim 7,
**characterized in that** two positions of circuit board test points and/or test markings are recorded, and the deviations of the circuit board test points from their ideal position are calculated as a linear misalignment and an angular misalignment from the recorded coordinates of these positions.

**10.** Method according to claim 7,
**characterized in that** three positions of circuit board test points and/or test markings are recorded, and the deviations of the circuit board test points from their ideal position are calculated as a linear misalignment, as an angular misalignment and as a misalignment due to linear distortion, from the recorded coordinates of these positions.

**11.** Method according to claim 7, **characterized in that** four positions of circuit board test points and/or test markings are recorded, and the deviations of the circuit board test points from their ideal position are calculated as a linear misalignment, as an angular misalignment and as a misalignment due to a 2-dimensional distortion, from the recorded coordinates of these positions.

**12.** Method according to one of the claims 7 to 11, **characterized in that** several zones of a printed circuit board to be tested are recorded, and the individual zones are analysed separately for deviation of the circuit board test points from their ideal position.

**13.** Method according to one of the claims 7 to 12, **characterized in that** several printed circuit boards to be tested are tested simultaneously, and the several printed circuit boards to be tested are recorded simultaneously, in order to determine the deviations of the circuit board test points from their ideal position.

**14.** Method of determining deviations of circuit board test points, for a method according to one of the claims 2 to 13, **characterized in that** in order to determine deviations of circuit board test points from their respective ideal positions, misalignments of a copper layer forming the circuit board test points are determined independently of misalignments of a solder resist coating.

**15.** Method according to claim 14, **characterized in that** the misalignments of the copper layer and the misalignments of the solder resist coating are determined by sets of circuit board test points or test markings which are independent of one another.

**16.** Method according to claim 14, **characterized in that** the misalignments of the copper layer and the misalignments of the solder resist coating are determined by sets of mixed circuit board test points or test markings.

**17.** Method according to one of the claims 1 to 16, **characterized in that** the parallel tester is so designed that it has no corresponding contact elements for circuit board test points which are in principle incapable of being contacted.

**18.** Apparatus for the implementation of a method according to one of the claims 1 to 16, for the testing of printed circuit boards, wherein the circuit boards have conductor paths, the end points of which are in the form of circuit board test points which may be contacted for testing, comprising:

- a parallel tester (2) provided with contact elements for the simultaneous contacting of circuit board test points of the printed circuit board to be tested,
- a device (16) for determination of circuit board test points which are either judged to be incapable of reliable correct contacting by the parallel tester, or which can basically not be contacted by the parallel tester, and
- a device (3) independent of the contact elements of the parallel tester for checking of circuit board test points and the associated conductor paths, wherein the circuit board test points are either judged to be incapable of reliable correct contacting by the parallel tester, or which can basically not be contacted by the parallel tester

FIG.1

```
        ┌─────────────┐
        │    Start    │─── S1
        └─────────────┘
   ┌──────────────────────┐
   │ Einlegen einer Leiter- │── S2
   │ platte in Paralleltester │
   └──────────────────────┘
   ┌──────────────────────┐
   │   optisches Erfassen   │── S3
   └──────────────────────┘
   ┌──────────────────────┐
   │   Versatzbestimmung    │── S4
   └──────────────────────┘
   ┌──────────────────────┐
   │  Ausrichten des Adapters │── S5
   └──────────────────────┘
   ┌──────────────────────┐
   │  Testen im Paralleltester │── S6
   └──────────────────────┘
   ┌──────────────────────┐
   │ Transport zum Fingertester │── S7
   └──────────────────────┘
   ┌──────────────────────┐
   │ Berechnen von weiteren  │── S8
   │ Versätzen und/oder Verzügen │
   └──────────────────────┘
   ┌──────────────────────┐
   │ Ermitteln nicht korrekt kontak- │── S9
   │ tierbarer Leiterplattentestpunkte │
   └──────────────────────┘
   ┌──────────────────────┐
   │     Nachmessen        │── S10
   └──────────────────────┘
   ┌──────────────────────┐
   │   Weitertransport      │── S11
   └──────────────────────┘
        ┌─────────────┐
        │    Ende     │─── S12
        └─────────────┘
```

## FIG.2

FIG.3

FIG.4

FIG.5a

FIG.5b

FIG.6a

Trapez

FIG.6b

FIG.7a

FIG.7b

Y

Bereich 2

Bereich 1

Bereich 0

X

FIG.8

23

24

24

20

21

B

A

FIG.9a

24

24

20

21

B

A

FIG.9b

FIG.10

FIG.11

FIG.12a

FIG.12b